# FASCICULE DE BREVET EUROPEEN

(11) **EP 4 026 243 B1**
(45) Date de publication et mention de la délivrance du brevet: **06.05.2026**
(21) Numéro de dépôt: 20764427.9
(22) Date de dépôt: 04.09.2020
(51) Int. Cl.: H03K 17/12, H03K 17/0812

(54) **ASSOCIATION DE TRANSISTORS**
TRANSISTORKOMBINATION
TRANSISTOR COMBINATION

(30) Priorité: 05.09.2019 FR 1909771
(43) Date de publication de la demande: 13.07.2022
(73) Titulaire: Commissariat à l'Energie Atomique et aux Energies Alternatives, 75015 Paris (FR)
(72) Inventeur: ESCOFFIER, René, 38054 GRENOBLE CEDEX 9 (FR); BUCKLEY, Julien, 38054 GRENOBLE CEDEX 9 (FR)
(74) Mandataire: Cabinet Beaumont
(86) Numéro de dépôt international: PCT/EP2020/074832
(87) Numéro de publication internationale: WO 2021/044017

(56) Documents cités:
- US-A1- 2016 352 318
- US-B1- 6 218 888
- US-B1- 6 218 888

## Description

La présente demande de brevet revendique la priorité de la demande de brevet français 19/09771.

### Domaine technique

La présente description concerne de façon générale les circuits électroniques et, plus particulièrement, les circuits électroniques mettant en œuvre des transistors à effet de champ qui sont fréquemment commutés entre un état passant et un état bloqué.

### Technique antérieure

On utilise parfois des transistors à effet de champ pour des applications d'électronique de puissance, c'est-à-dire des applications mettant en jeu des courants électriques de forte intensité, typiquement supérieurs à 10 A. Ces transistors à effet de champ ont alors des dimensions importantes, leur permettant de supporter ces courants de forte intensité. Du fait de leurs dimensions importantes, ces transistors possèdent souvent de grandes surfaces de grille, typiquement comprises entre 5 et 20 mm², donc de fortes capacités de grille.

Les capacités de grille sont usuellement qualifiées de parasites, car elles sont à l'origine de pertes énergétiques à chaque fois qu'elles sont chargées. Dans le cas, par exemple, de systèmes de conversion d'énergie qui opèrent à des fréquences élevées, de nombreuses commutations du transistor, entre l'état passant et l'état bloqué, ont lieu pendant des durées très courtes. Ces commutations répétées engendrent d'importantes pertes énergétiques, dues à de nombreux cycles de charge et de décharge des capacités de grille.

De tels systèmes de conversion d'énergie sont, par exemple, embarqués sur des véhicules électriques alimentés par des batteries. Ces véhicules disposent, par nature, d'une source d'énergie limitée. On cherche donc généralement à limiter les pertes énergétiques, autrement dit à maximiser le rendement, des différents systèmes embarqués sur ces véhicules. Cela permet notamment d'optimiser leur autonomie.

US 2016/352318 A1 divulgue un circuit de type IGBT équipé d'un circuit de limitation de courant. US 6 218 888 B1 divulgue le contrôle d'un circuit de blocage pendant des conditions transitoires.

### Résumé de l'invention

Il existe un besoin de réduire les pertes énergétiques des systèmes de conversion d'énergie comportant des transistors à effet de champ.

Un mode de réalisation pallie tout ou partie des inconvénients des systèmes de conversion d'énergie connus.

L'invention est définie par les revendications indépendantes. Les revendications dépendantes couvrent des modes de réalisation et variantes de l'invention.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
La figure 1 représente, de façon schématique, un mode de réalisation d'un circuit électronique destiné à être connecté en série avec une charge ;
La figure 2 représente, de façon schématique, un autre mode de réalisation d'un circuit électronique destiné à être connecté en série avec une charge ;
La figure 3 représente, de façon schématique, encore un autre mode de réalisation d'un circuit électronique destiné à être connecté en série avec une charge ;
La figure 4 représente, par des vues (A) et (B), des chronogrammes illustrant le fonctionnement du circuit décrit en relation avec la figure 1 ;
La figure 5 représente, de façon très schématique et sous forme de blocs, un mode de réalisation d'un système de gestion d'énergie ; et
La figure 6 illustre un exemple d'intégration, dans un véhicule, du système tel que décrit en relation avec la figure 5.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation des figures, étant entendu que, en pratique, les dispositifs décrits peuvent être orientés différemment.

Sauf précision contraire, les expressions "environ", "approximativement", "sensiblement", et "de l'ordre de" signifient à 10 % près, de préférence à 5 % près.

Dans la description qui suit, on désigne par l'expression « tension grille-source » une tension appliquée ou présente entre la grille et la source d'un transistor à effet de champ. En d'autres termes, la tension grille-source correspond à une différence entre un potentiel électrique auquel est soumise la borne de grille et un potentiel électrique auquel est soumise la borne de source de ce transistor à effet de champ.

En outre, on désigne par l'expression « tension de seuil » une valeur minimale de la tension grille-source à partir de laquelle un transistor à effet de champ commute entre un état bloqué et un état passant. Pour un transistor MOS à canal n, la tension de seuil correspond à une valeur de tension grille-source positive en dessous de laquelle le transistor est dans un état bloqué et au-dessus de laquelle le transistor est dans un état passant. Inversement, pour un transistor MOS à canal p, la tension de seuil correspond à une valeur de tension grille-source négative en dessous de laquelle le transistor est passant et au-dessus de laquelle le transistor est bloqué.

Afin de pouvoir charger et décharger des capacités de grille en un temps suffisamment court pour convenir aux applications de conversion d'énergie visées, on pourrait penser à utiliser des circuits de commande (drivers) capables de délivrer des courants atteignant une dizaine d'ampères. Outre le fait que de tels circuits de commande sont généralement onéreux et encombrants, ils entraîneraient également d'importantes pertes par effet Joule, en raison de la présence d'une résistance de grille traditionnellement utilisée pour limiter d'éventuelles oscillations lors des commutations. Pour une résistance de grille comprise entre 5 et 20 Ω, l'énergie perdue à chaque seconde, pour une fréquence de fonctionnement de 500 kHz, serait alors typiquement de l'ordre de 0,25 à 1 J. Ces pertes seraient préjudiciables au rendement du système de conversion d'énergie.

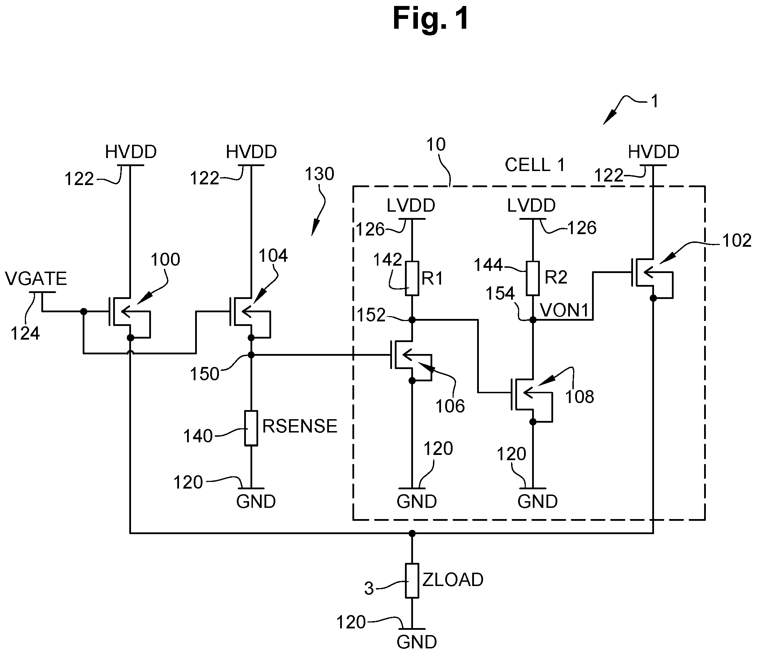

La figure 1 représente, de façon schématique, un mode de réalisation d'un circuit électronique 1 destiné à être connecté en série avec une charge 3 (ZLOAD).

Selon ce mode de réalisation, le circuit 1 comporte une première cellule 10 (CELL 1) couplée en parallèle d'un premier transistor 100. Cette première cellule 10 est également appelée portion, branche ou partie du circuit 1. La première cellule 10 du circuit 1 comporte un deuxième transistor 102 adapté à être commuté en fonction de l'intensité d'un courant électrique transmis à la charge 3. Le deuxième transistor 102 est couplé en parallèle du premier transistor 100, tandis que le premier transistor 100 et le deuxième transistor 102 sont associés en série avec la charge 3.

Plus précisément, en figure 1, la source du premier transistor 100 et la source du deuxième transistor 102 sont reliées, de préférence connectées, à une borne de la charge 3. Une autre borne de la charge 3 est reliée, de préférence connectée, à une première borne 120 d'application d'un potentiel de référence, par exemple la masse (GND). Le drain du premier transistor 100 et le drain du deuxième transistor 102 sont quant à eux reliés, de préférence connectés, à une deuxième borne 122 d'application d'un potentiel d'alimentation (HVDD) de la charge 3.

Le circuit 1 comporte, en outre, un capteur de courant 130 adapté à détecter ou évaluer une information représentative du courant électrique transmis à la charge 3. Ce capteur de courant 130 comprend un troisième transistor 104 associé en série avec une première résistance 140 (RSENSE). Une borne de cette première résistance 140 est reliée, de préférence connectée, à la source du troisième transistor 104. L'autre borne de cette première résistance 140 est reliée, de préférence connectée, à la première borne 120 d'application du potentiel de référence GND. Le drain du troisième transistor 104 est quant à lui relié, de préférence connecté, à la deuxième borne 122 d'application du potentiel HVDD.

Le troisième transistor 104 est monté en miroir sur le premier transistor 100. En figure 1, la grille du premier transistor 100 et la grille du troisième transistor 104 sont toutes deux reliées, de préférence connectées, à une même troisième borne 124 d'application d'un potentiel de grille, noté VGATE. Cela permet ainsi d'obtenir, aux bornes de la première résistance 140, une tension proportionnelle au courant électrique transmis à la charge 3. En d'autres termes, le troisième transistor 104 joue le rôle d'un capteur de courant.

À l'intérieur de la première cellule 10 du circuit 1, un quatrième transistor 106 est associé en série avec une deuxième résistance 142 (R1). La source de ce quatrième transistor 106 est reliée, de préférence connectée, à la première borne 120 d'application du potentiel de référence GND. Le drain du quatrième transistor 106 est relié, de préférence connecté, à une borne de la deuxième résistance 142. L'autre borne de cette deuxième résistance 142 est reliée, de préférence connectée, à une quatrième borne 126 d'application d'un potentiel de commande (LVDD). La grille du quatrième transistor 106 est reliée, de préférence connectée, à un premier nœud 150 d'interconnexion situé entre la source du troisième transistor 104 et la première résistance 140. Le premier nœud 150 d'interconnexion constitue ici une sortie du capteur 130.

Le potentiel de commande LVDD est, de préférence, inférieur au potentiel d'alimentation HVDD. Le potentiel de commande LVDD est, par exemple, de l'ordre de 5 à 10 V tandis que le potentiel d'alimentation HVDD est, par exemple, de l'ordre de 400 V.

De façon analogue, toujours à l'intérieur de la première cellule 10 du circuit 1, un cinquième transistor 108 est associé en série avec une troisième résistance 144 (R2). La source de ce cinquième transistor 108 est reliée, de préférence connectée, à la première borne 120 d'application du potentiel de référence GND. Le drain du cinquième transistor 108 est relié, de préférence connecté, à une borne de la troisième résistance 144. L'autre borne de cette troisième résistance 144 est reliée, de préférence connectée, à la quatrième borne 126 d'application du potentiel LVDD. La grille du cinquième transistor 108 est reliée, de préférence connectée, à un deuxième nœud 152 situé entre le drain du quatrième transistor 106 et la deuxième résistance 142.

La grille du deuxième transistor 102 est reliée, de préférence connectée, à un troisième nœud 154 situé entre le drain du cinquième transistor 108 et la troisième résistance 144.

Le premier transistor 100, le deuxième transistor 102, le troisième transistor 104, le quatrième transistor 106 et le cinquième transistor 108 sont, de préférence, des transistors MOS. Ces transistors 100, 102, 104, 106 et 108 peuvent être, par exemple, des transistors à effet de champ à grille isolée (Metal Oxide Semiconductor Field Effect Transistor - MOSFET ou Metal Insulator Semiconductor Field Effect Transistor - MISFET), des transistors à effet de champ à jonction (Junction Field Effect Transistor - JFET), des transistors semiconducteurs à oxyde métallique diffusé latéralement (Laterally Diffused Metal Oxide Semiconductor - LDMOS), des transistors à haute mobilité d'électrons (High Electron Mobility Transistor - HEMT), etc.

Dans la description qui suit, on considère que le premier transistor 100, le deuxième transistor 102, le troisième transistor 104, le quatrième transistor 106 et le cinquième transistor 108 sont des transistors MOS à canal n.

Au cours d'une première phase de fonctionnement du circuit 1, on suppose que la charge 3 appelle un courant dont l'intensité est telle que la tension aux bornes de la première résistance 140 du capteur de courant 130, c'est-à-dire le potentiel électrique au premier nœud 150, ne soit pas suffisamment élevée pour faire commuter le quatrième transistor 106 d'un état bloqué à un état passant. En d'autres termes, on fait l'hypothèse que la tension grille-source du quatrième transistor, qui est approximativement égale à la tension entre le premier nœud 150 et la première borne 120, est inférieure à la tension de seuil de ce quatrième transistor 106. Le quatrième transistor 106 se trouve donc à l'état bloqué. Le potentiel au deuxième nœud 152 est ainsi sensiblement égal au potentiel LVDD appliqué sur la quatrième borne 126.

Le potentiel LVDD est en pratique choisi pour que la tension grille-source du cinquième transistor 108, qui, dans cette phase, est approximativement égale à la tension entre le deuxième nœud 152 et la première borne 120, soit supérieure à la tension de seuil de ce cinquième transistor 108. Le cinquième transistor 108 se trouve donc à l'état passant. Le potentiel présent au troisième nœud 154, notée VON1, est par conséquent sensiblement égal au potentiel de référence GND appliqué sur la première borne 120, aux chutes de tension près liées à la résistance interne entre le drain et la source du cinquième transistor 108 à l'état passant. Dans le circuit 1, cela revient à mettre le troisième nœud 154 à la masse. La tension grille-source du deuxième transistor 102 est alors inférieure à la tension de seuil de ce deuxième transistor 102. Le deuxième transistor 102 est donc bloqué lors de cette première phase de fonctionnement.

Au cours d'une deuxième phase de fonctionnement du circuit 1, on suppose que la charge 3 appelle un courant dont l'intensité, supérieure à celle de la première phase de fonctionnement, est telle que la tension aux bornes de la première résistance 140 du capteur de courant 130 soit suffisamment élevée pour faire commuter le quatrième transistor 106 d'un état bloqué à un état passant. En d'autres termes, on fait l'hypothèse que la tension grille-source du quatrième transistor est, dans cette deuxième phase, supérieure à la tension de seuil de ce quatrième transistor 106. Le quatrième transistor 106 se trouve donc à l'état passant. Le potentiel au deuxième nœud 152 est ainsi sensiblement égal au potentiel de référence GND appliqué sur la première borne 120, aux chutes de tension près liées à la résistance interne entre le drain et la source du quatrième transistor 106 à l'état passant. Dans le circuit 1, cela revient à mettre le deuxième nœud 152 à la masse.

La tension grille-source du cinquième transistor 108 est dans ce cas inférieure à la tension de seuil du cinquième transistor 108. Le cinquième transistor 108 se trouve donc à l'état bloqué. Le potentiel VON1 présent au troisième nœud 154 est par conséquent sensiblement égal au potentiel de commande LVDD appliqué sur la quatrième borne 126. La tension de commande LVDD est en pratique choisie pour que la tension grille-source du deuxième transistor 102 soit alors supérieure à la tension de seuil de ce deuxième transistor 102. Le deuxième transistor 102 est donc passant lors de cette deuxième phase de fonctionnement.

En choisissant la tension de seuil du troisième transistor 104, ou la valeur de la résistance 140, en fonction d'une application donnée, on peut ainsi ajuster un seuil de courant transmis à la charge 3 au-dessus duquel le deuxième transistor 102 est commuté à l'état passant et en dessous duquel ce deuxième transistor 102 est à l'état bloqué. Selon un mode de réalisation préféré, on choisit le troisième transistor 104 de telle sorte que sa tension de seuil permette de commuter le deuxième transistor 102 à l'état passant lorsque le courant transmis à la charge 3 est égal à une fraction du courant maximal pouvant être transmis à cette charge 3.

Par rapport à un circuit de conversion d'énergie ne comportant qu'un seul transistor de puissance, la présence, dans le circuit 1, du premier transistor 100 et du deuxième transistor 102 permet avantageusement de rendre le nombre de transistors utilisés fonction de la demande en courant de la charge 3. Par exemple, seul le premier transistor 100 est utilisé lors de phases où la demande en courant de la charge 3 est moindre, par rapport à d'autres phases où la demande en courant est supérieure et où les deux transistors 100 et 102 sont utilisés. On réduit ainsi de manière significative les pertes énergétiques, en limitant les capacités de grille chargées et déchargées pendant les phases où la demande en courant est moindre, tout en restant pleinement compatible avec les phases où la demande en courant est supérieure.

En pratique, le premier transistor 100 et le deuxième transistor 102 sont des transistors qui sont dimensionnés pour admettre conjointement le courant maximal pouvant être transmis à la charge dans l'application considérée. À titre d'exemple, dans le cas d'une application où la charge est susceptible d'appeler un courant d'une intensité maximale de 80 A, le premier transistor 100 et le deuxième transistor 102 sont, par exemple, des transistors comportant 200 doigts de 1 mm et caractérisés par un calibre en courant de 40 A. Le troisième transistor 104 est, par exemple, un transistor caractérisé par un calibre en courant vingt fois inférieur à celui du premier transistor 100 et du deuxième transistor 102. Le quatrième transistor 106 est, par exemple, un transistor comportant 20 doigts. Le cinquième transistor 108 est, par exemple, un transistor comportant 10 doigts.

La première résistance 140 est dimensionnée de telle sorte que la tension présente à ses bornes lorsque le courant transmis à la charge 3 est maximal ne dépasse pas la tension grille-source maximale admissible par le troisième transistor 104, cette tension grille-source maximale admissible par le troisième transistor 104 étant ici de l'ordre de 5 V. Toujours à titre d'exemple :
la résistance électrique de la première résistance 140 est d'environ 100 Ω ;
la résistance électrique de la deuxième résistance 142 est d'environ 10 kΩ ; et
la résistance électrique de la troisième résistance 144 est d'environ 10 kΩ.

Un avantage du circuit 1 réside dans le fait qu'il permet de piloter un premier transistor 100 et un deuxième transistor 102 possédant des tensions de seuil différentes. En supposant que le premier transistor 100 possède une tension de seuil de 1 V et que le deuxième transistor 102 possède une tension de seuil de 2 V, on peut en effet adapter la tension de commande LVDD, appliquée sur la quatrième borne 126, pour rendre le fonctionnement du circuit 1 compatible avec la tension de seuil du deuxième transistor 102. Cette adaptation de la tension de commande LVDD n'impacte toutefois pas la tension de grille VGATE, relative à la source du premier transistor 100, appliquée sur la troisième borne 124, qui peut être rendue compatible avec la tension de seuil du premier transistor 100 de façon totalement indépendante.

Un autre avantage du circuit 1 réside dans le fait qu'il permet, en outre, d'utiliser un premier transistor 100 et un deuxième transistor 102 de tailles différentes pour diviser ou partager le courant transmis à la charge 3. À titre d'exemple, on considère une application dans laquelle la charge 3 appelle, en régime transitoire, un courant d'environ 40 A et, en régime permanent ou établi, un courant d'environ 10 A seulement. On peut alors dimensionner le troisième transistor 104 pour que sa tension de seuil corresponde à un courant transmis à la charge 3 légèrement supérieur au courant appelé en régime permanent.

On peut, toujours selon cet exemple, choisir le troisième transistor 104 pour que sa tension de seuil corresponde à un courant transmis à la charge 3 de l'ordre de 12 A. Dans le circuit 1, seul le premier transistor 100 est ainsi commuté en régime permanent, le deuxième transistor 102 n'étant quant à lui commuté que lors du régime transitoire. Cela permet d'utiliser avantageusement un premier transistor 100 de calibre plus petit que celui du deuxième transistor 102 (environ quatre fois plus petit, dans cet exemple). La capacité de grille de ce premier transistor 100 est ainsi plus faible que celle du deuxième transistor 102, ce qui permet de réduire encore davantage les pertes énergétiques du circuit 1 et les durées nécessaires à la commutation. Cela permet ainsi d'obtenir un circuit 1 présentant, par rapport aux circuits de conversion d'énergie usuels, un rendement supérieur et une dynamique meilleure.

Encore un autre avantage du circuit 1 réside dans le fait qu'il ne comporte aucun microcontrôleur pour commander la commutation du deuxième transistor 102. Cela permet ainsi d'avoir un circuit 1 présentant un temps de réponse supérieur aux systèmes usuels comportant des microcontrôleurs et une architecture plus simple.

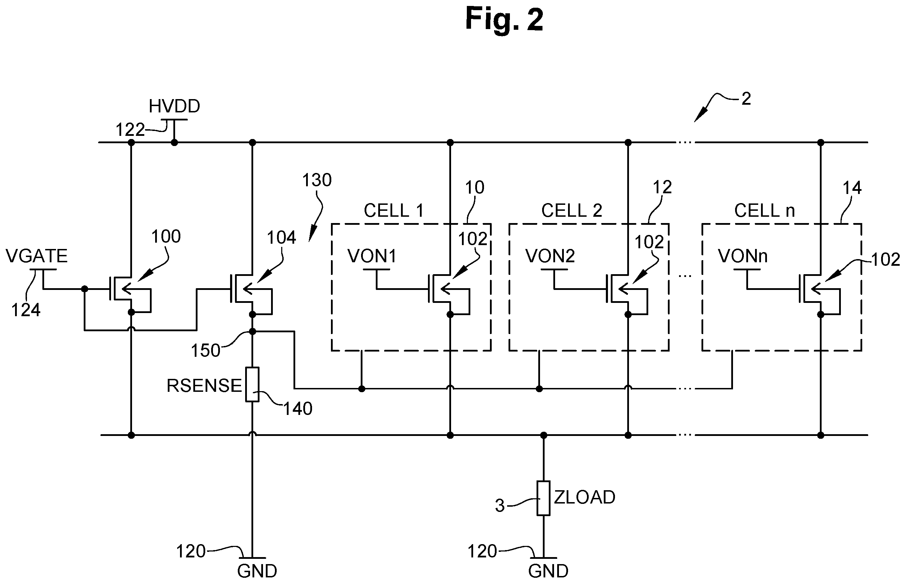

La figure 2 représente, de façon schématique, un autre mode de réalisation d'un circuit électronique 2 destiné à être connecté en série avec la charge 3. Le circuit 2 de la figure 2 comprend des éléments communs avec le circuit 1 de la figure 1. Ces éléments communs ne seront pas détaillés à nouveau ci-après. Le circuit 2 de la figure 2 diffère du circuit 1 de la figure 1 principalement en ce qu'il comporte plusieurs cellules analogues à la première cellule CELL 1, par exemple au total n cellules CELL i (i allant de 1 à n).

En figure 2, trois cellules 10 (CELL 1), 12 (CELL 2) et 14 (CELL n) ont été représentées. Le circuit 2 peut toutefois comporter un nombre quelconque de cellules. Dans l'exemple de la figure 2, toutes les cellules 10, 12 et 14 comportent chacune un deuxième transistor 102. Le nombre de cellules du circuit 2 équivaut donc au nombre de deuxièmes transistors 102 de ce circuit 2. Le circuit 2 comporte, en pratique, entre un et cinquante deuxièmes transistors, de préférence entre un et vingt deuxièmes transistors, plus préférentiellement trois ou quatre deuxièmes transistors.

Dans le circuit 2, la grille du deuxième transistor 102 de la deuxième cellule 12 est soumise à un potentiel noté VON2. De façon analogue, la grille du deuxième transistor 102 de la troisième cellule 14 est soumise à un potentiel noté VONn. Ces potentiels VON2 et VONn déterminent l'état, passant ou bloqué, des deuxièmes transistors 102 des cellules 12 et 14, respectivement. Les potentiels VON2 et VONn sont, de préférence, créés ou appliqués de la même façon que le potentiel VON1, comme exposé en relation avec la figure 1.

Dans le mode de réalisation de la figure 2, les grilles des deuxièmes transistors 102 des cellules 10, 12 et 14 sont reliées à la sortie d'un capteur 130 commun. En d'autres termes, le circuit 2 ne comporte qu'un seul capteur 130.

La deuxième cellule 12 et la troisième cellule 14 du circuit 2 possèdent chacune un quatrième transistor 106 (non représenté en figure 2) dont la grille est reliée, de préférence connectée, au nœud 150 du capteur 130 commun. En ajustant la tension de seuil de chaque quatrième transistor 106 et/ou en ajustant les valeurs des résistances R1 et R2 (non représentées en figure 2) de chaque cellule 10, 12 et 14, on peut avantageusement faire en sorte de répartir le courant transmis à la charge 3 sur tout ou partie des premier et deuxièmes transistors 100, 102 du circuit 2.

On choisit alors le nombre de deuxièmes transistors 102 du circuit 2, et la tension de seuil des quatrièmes transistors 106 auxquels ils sont associés et/ou la valeur des résistances R1 et R2, en fonction d'une discrétisation ou répartition du courant visée. En particulier, plus le nombre de deuxièmes transistors 102 est important, plus il est possible de faire en sorte que les capacités de grille qui sont alternativement chargées et déchargées soient en cohérence avec des variations du courant transmis à la charge 3.

Un autre avantage du circuit 2 réside dans le fait que cette répartition du courant transmis à la charge 3 dans plusieurs transistors de puissance (le premier transistor 100 et les deuxièmes transistors 102, dans le cas du circuit 2) permet une diminution de surface occupée par chaque transistor. Dans un mode de réalisation où le circuit 2 est réalisé dans une plaquette de silicium (wafer), cette diminution de surface permet une optimisation du rendement énergétique.

Encore un autre avantage du circuit 2 réside dans le fait que ce circuit 2 n'utilise qu'un seul capteur de courant 130 pour piloter l'activation et la désactivation de plusieurs cellules de façon indépendante. Cela permet notamment de limiter l'espace occupé par le circuit 2.

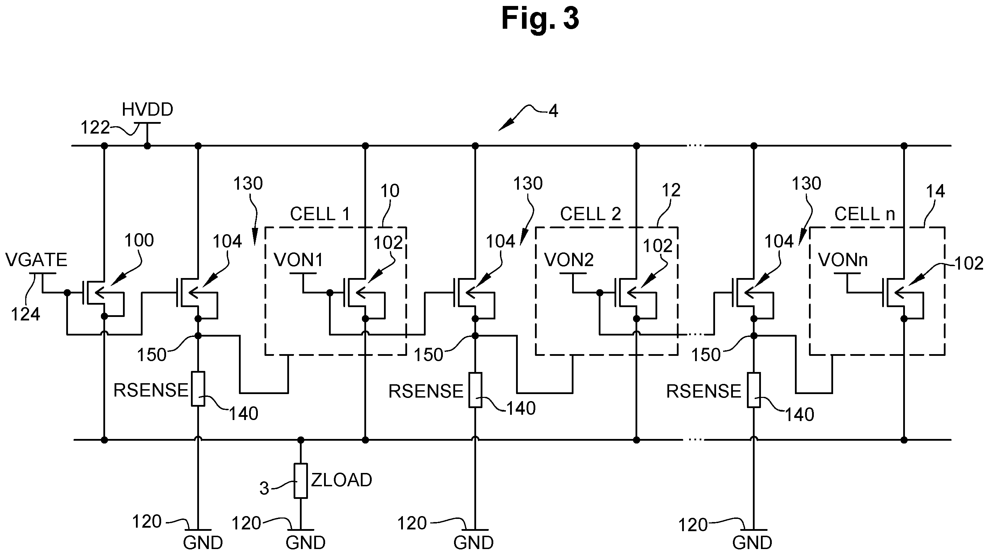

La figure 3 représente, de façon schématique, un autre mode de réalisation d'un circuit électronique 4 destiné à être connecté en série avec la charge 3. Le circuit 4 de la figure 3 comprend des éléments communs avec le circuit 2 de la figure 2. Ces éléments communs ne seront pas détaillés à nouveau ci-après. Le circuit 4 de la figure 3 diffère du circuit 2 de la figure 2 principalement en ce que chaque cellule 10, 12 et 14 est associée à un capteur de courant 130 qui lui est propre.

En figure 3, trois cellules 10, 12 et 14 et trois capteurs de courant 130 associés ont été représentés. Le circuit 4 peut toutefois comporter un nombre quelconque de cellules, équivalant au nombre de deuxièmes transistors 102. Le circuit 4 comporte, en pratique, entre un et cinquante deuxièmes transistors, de préférence entre un et vingt deuxièmes transistors, plus préférentiellement trois ou quatre deuxièmes transistors.

Dans le mode de réalisation de la figure 3, les grilles des deuxièmes transistors 102 des cellules 10, 12 et 14 sont chacune reliées à la sortie d'un capteur 130 associé. Dans le cas du circuit 4, chaque transistor 102 est donc relié à un capteur 130 qui lui est propre, contrairement au cas du circuit 2 dans lequel tous les transistors 102 sont reliés à un capteur 130 commun.

La deuxième cellule 12 et la troisième cellule 14 du circuit 4 possèdent chacune un troisième transistor 104 (non représenté en figure 3) dont la grille est reliée, de préférence connectée, au premier nœud 150 du capteur 130 associé. En ajustant la valeur de la résistance RSENSE du capteur 130 associé à chaque cellule 10, 12 et 14, on peut avantageusement faire en sorte de répartir le courant transmis à la charge 3 sur tout ou partie des premier et deuxièmes transistors 100, 102 du circuit 4.

On choisit alors le nombre de deuxièmes transistors 102 du circuit 4 et la valeur des résistances RSENSE en fonction d'une discrétisation ou répartition du courant visée pour obtenir des avantages analogues à ceux exposés en relation avec la figure 2.

À titre de variante, on peut combiner les modes de réalisation décrits en relation avec les figures 2 et 3. On peut en particulier prévoir un circuit comportant une pluralité de capteurs 130, dans lequel chaque capteur 130 est associé à un ou plusieurs deuxièmes transistors 102. Dans un tel circuit comportant un premier nombre de deuxièmes transistors 102 et un deuxième nombre de capteurs 130, le deuxième nombre est alors strictement inférieur au premier nombre.

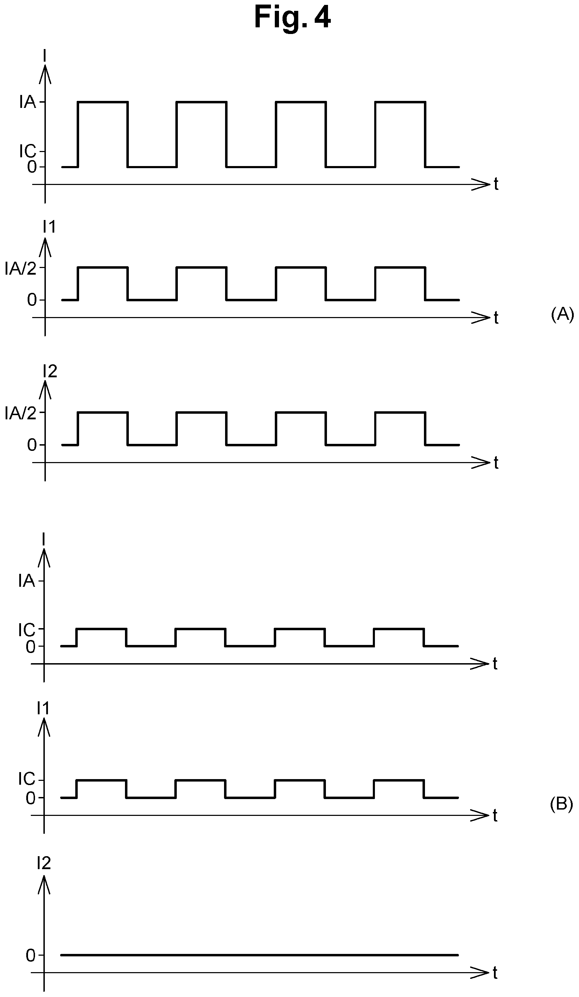

La figure 4 représente, par des vues (A) et (B), des chronogrammes illustrant le fonctionnement du circuit 1 décrit en relation avec la figure 1.

À titre d'exemple, on considère, en figure 4, que le circuit 1 est utilisé dans un véhicule électrique pour convertir un courant continu provenant d'une batterie en un courant alternatif alimentant un moteur adapté à propulser ce véhicule (conversion de type DC/AC). Le moteur joue alors le rôle de la charge 3, la tension HVDD d'alimentation du moteur étant fournie par la batterie. On s'intéresse uniquement, toujours dans cet exemple, à deux phases de fonctionnement :
une première phase de fonctionnement, illustrée en vue (A), durant laquelle le véhicule accélère ; et
une deuxième phase de fonctionnement, illustrée en vue (B), durant laquelle le véhicule roule à allure stabilisée, c'est-à-dire à vitesse constante.

En figure 4, on note IA l'intensité maximale du courant alternatif transmis au moteur lors de la première phase de fonctionnement et IC l'intensité maximale du courant alternatif transmis au moteur lors de la deuxième phase de fonctionnement. Cette intensité maximale IC appelée lorsque le véhicule circule à vitesse constante est inférieure à l'intensité maximale IA appelée lorsque le véhicule accélère. À titre d'exemple, on considère arbitrairement que l'intensité IA est quatre fois supérieure à l'intensité IC.

Pour simplifier, on suppose que le premier transistor 100 est identique au deuxième transistor 102. On suppose, en outre, que le troisième transistor 104 est commuté de l'état bloqué à l'état passant à partir d'un courant supérieur à IC et inférieur à IA.

En figure 4, on s'intéresse à une évolution en fonction du temps (t) :
d'un courant alternatif, noté I, transmis à la charge 3 ;
d'un courant alternatif, noté I1, parcourant le premier transistor 100 ; et
d'un courant alternatif, noté I2, parcourant le deuxième transistor 102.

Le chronogramme de la vue (A) illustre la première phase de fonctionnement, lorsque le courant I transmis à la charge 3 oscille périodiquement entre 0 et IA. Le troisième transistor 104 du circuit 1 est passant chaque fois que le courant I est égal à IA et bloqué chaque fois que le courant I est égal à 0. Le courant I est alors réparti sur le premier transistor 100 et sur le deuxième transistor 102. Le courant I1 parcourant le premier transistor 100 est donc environ égal à la moitié du courant I. En vue (A), ce courant I1 oscille ainsi en phase avec le courant I entre des valeurs 0 et IA/2.

De façon analogue, le courant I2 parcourant le deuxième transistor 102 est environ égal à la moitié du courant I. En vue (A), ce courant I2 oscille ainsi en phase avec le courant I entre les valeurs 0 et IA/2. En d'autres termes, le courant I transmis à la charge 3 lors de la première phase de fonctionnement est réparti de façon sensiblement équitable entre le premier transistor 100 et le deuxième transistor 102.

Le chronogramme de la vue (B) illustre la deuxième phase de fonctionnement, lorsque le courant I transmis à la charge 3 oscille périodiquement entre 0 et IC. Le troisième transistor 104 du circuit 1 est bloqué en permanence. Le courant I1 traversant le premier transistor 100 est alors sensiblement égal au courant I transmis à la charge 3. En vue (B), ce courant I1 oscille ainsi en phase avec le courant I entre les valeurs 0 et IC.

En revanche, le courant I2 parcourant le deuxième transistor 102 est, dans cette phase de fonctionnement, sensiblement nul. En vue (B), ce courant I2 demeure environ égal à 0, aux fuites de courant près entre la source et le drain du deuxième transistor 102. En d'autres termes, le courant I transmis à la charge 3 lors de la deuxième phase de fonctionnement est uniquement affecté au premier transistor 100.

Le fonctionnement du circuit 1 illustré ci-dessus permet de solliciter uniquement le premier transistor 100 lors de la deuxième phase, pendant laquelle le véhicule roule à vitesse constante. On diminue ainsi la capacité de grille mise en jeu lors des commutations durant cette deuxième phase de fonctionnement, ce qui permet par conséquent d'améliorer l'efficacité énergétique du circuit 1 et d'effectuer des commutations à une fréquence plus élevée.

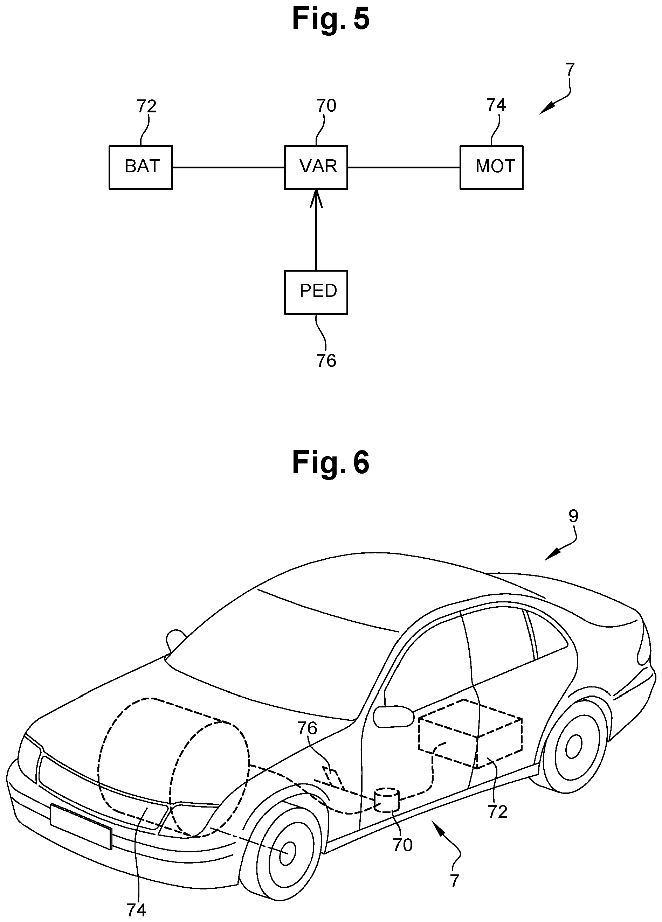

La figure 5 représente, de façon très schématique et sous forme de blocs, un mode de réalisation d'un système 7 de gestion d'énergie.

En figure 5, le système 7 de gestion d'énergie comporte un variateur 70 (VAR) permettant de réguler un courant électrique fourni par une source d'énergie ou batterie 72 (BAT) à un moteur électrique 74 (MOT). Le variateur 70 est piloté par une consigne provenant d'une pédale 76 (PED). On suppose, par exemple, que le moteur 74 est entraîné en rotation à une vitesse asservie en fonction de la consigne provenant de la pédale 76. Selon ce mode de réalisation, le variateur 70 comprend un circuit analogue au circuit 1 de la figure 1, au circuit 2 de la figure 2 ou au circuit 4 de la figure 3.

En fonction de la consigne transmise au variateur 70 par l'intermédiaire de la pédale 76, un courant plus ou moins important est transmis au moteur 74. En considérant qu'une modification de la position de la pédale conduit à une situation dans laquelle le moteur accélère et qu'un maintien de la pédale dans une même position conduit à une autre situation dans laquelle le moteur tourne à vitesse constante, on se ramène à un mode de fonctionnement comportant deux phases analogues à celles exposées en relation avec la figure 4.

La figure 6 illustre un exemple d'intégration, dans un véhicule 9, du système 7 tel que décrit en relation avec la figure 5.

En figure 6, le système 7 permet, par exemple, de contrôler la vitesse de déplacement du véhicule 9 en fonction de la consigne transmise par l'intermédiaire de la pédale 76, actionnée par un conducteur (non représenté) de ce véhicule 9. L'utilisation, dans le variateur 70, d'un circuit analogue aux circuits 1 et 2 précédemment décrits permet d'optimiser le rendement énergétique de ce variateur 70, donc de diminuer la décharge de la batterie 72 embarquée sur le véhicule 9. On augmente ainsi l'autonomie du véhicule 9.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, ce qui est exposé plus particulièrement en relation avec un exemple d'application à un circuit de gestion d'énergie d'un véhicule motorisé s'applique plus généralement à tout système ou procédé de gestion d'énergie fournie par une source et consommée par une charge. En outre, la transposition des modes de réalisation décrits à des circuits de gestion d'énergie comportant d'autres types de transistors à effet de champ, notamment des transistors MOS à canal p, est à la portée de l'homme du métier à partir des indications ci-dessus.

Enfin, la mise en œuvre pratique des modes de réalisation et variantes décrits est à la portée de l'homme du métier à partir des indications fonctionnelles données ci-dessus. En particulier, le dimensionnement et le nombre de cellules ou de deuxièmes transistors 102 peut être ajusté en fonction de l'application à partir des indications ci-dessus.

## Revendications

1. Circuit (1 ; 2 ; 4), destiné à être associé en série avec une charge à alimenter (3), comportant :
un premier transistor à effet de champ (100) ;
au moins un deuxième transistor à effet de champ (102), en parallèle sur le premier transistor ; et
au moins un capteur (130) d'une information représentative d'un courant (I) transmis à ladite charge, chaque capteur (130) comprenant un troisième transistor à effet de champ (104), la grille du premier transistor (100) et la grille du troisième transistor (104) étant reliées, de préférence connectées, à une même borne (124) d'application d'un potentiel de grille (VGATE) et la grille du deuxième transistor étant reliée à une sortie (150) dudit capteur,
dans lequel l'association en série des transistors (100, 102) et de la charge (3) est connectée entre :
une borne (122) d'application d'un potentiel d'alimentation (HVDD) de la charge, à laquelle sont connectés le drain du premier transistor (100), le drain du ou des deuxièmes transistors (102) et le drain du troisième transistor (104) ; et
une borne (120) d'application d'un potentiel de référence (GND),
le troisième transistor (104) étant associé en série avec une première résistance (140), dont une première borne est connectée à la source du troisième transistor (104) et dont une deuxième borne est connectée à la borne (120) d'application du potentiel de référence (GND),
dans lequel chaque capteur (130) est relié à la grille du ou des deuxièmes transistors (102) par l'intermédiaire d'un circuit de commande comprenant :
un quatrième transistor (106) associé en série avec une deuxième résistance (142), dont une première borne est connectée au drain du quatrième transistor (106) et dont une deuxième borne est connectée à une borne (126) d'application d'un potentiel de commande (LVDD) ; et
un cinquième transistor (108) associé en série avec une troisième résistance (144), dont une première borne est connectée au drain du cinquième transistor (108) et dont une deuxième borne est connectée à la borne d'application (126) du potentiel de commande (LVDD),
la grille du deuxième transistor (102) étant connectée entre le cinquième transistor (108) et la troisième résistance (144), la grille du quatrième transistor (106) étant connectée à un nœud (150) d'interconnexion du troisième transistor (104) et de la première résistance (140), et la grille du cinquième transistor (108) étant connectée entre le quatrième transistor (106) et la deuxième résistance (142).

2. Circuit selon la revendication 1 comprenant plusieurs deuxièmes transistors (102) et plusieurs capteurs (130), la grille de chaque deuxième transistor étant reliée à la sortie (150) d'un capteur (130) associé.

3. Circuit selon la revendication 1 comportant plusieurs deuxièmes transistors (102), les grilles des deuxièmes transistors (102) étant reliées à la sortie (150) d'un capteur (130) commun.

4. Circuit selon la revendication 1 comportant un premier nombre de deuxièmes transistors (102) et un deuxième nombre de capteurs (130), strictement inférieur au premier nombre, chaque capteur étant associé à un ou plusieurs deuxièmes transistors.

5. Circuit selon l'une quelconque des revendications 1 à 4, dans lequel l'association en parallèle des transistors (100, 102) comporte entre un et cinquante deuxièmes transistors (102), de préférence entre un et vingt deuxièmes transistors, plus préférentiellement trois ou quatre deuxièmes transistors.

6. Circuit selon l'une quelconque des revendications 1 à 5, dans lequel un état passant ou bloqué du deuxième transistor (102) dépend de la tension présente audit nœud (150) d'interconnexion du troisième transistor (104) et de la première résistance (140).

7. Procédé de commande d'un circuit (1 ; 2 ; 4) selon l'une quelconque des revendications 1 à 6, dans lequel le deuxième transistor (102) est commandé en fonction d'un courant (I) transmis à la charge (3), le courant étant évalué par ledit au moins un capteur (130).

8. Système (7) comprenant :
un circuit (1 ; 2 ; 4) selon l'une quelconque des revendications 1 à 6 ;
une charge (3 ; 74) ; et
une source d'énergie (72).

9. Véhicule électrique (9) comprenant un système (7) selon la revendication 8.

## Patentansprüche

1. Schaltung (1; 2; 4), die dazu vorgesehen ist, in Reihe mit einer zu betreibenden Last (3) verbunden zu werden, das Folgendes aufweist:
einen ersten Feldeffekt-Transistor (100);
wenigstens einen zweiten Feldeffekt-Transistor (102), parallel zu dem ersten Transistor;
und wenigstens einen Sensor (130) für Information, die für einen zu der Last übertragenen Strom (I) repräsentativ ist,
wobei jeder Sensor (130) einen dritten Feldeffekt-Transistor (104) aufweist, wobei das Gate des ersten Transistors (100) und das Gate des dritten Transistors (104) gekoppelt sind, vorzugsweise verbunden sind, mit einem selben Anschluss (124) zum Anlegen eines Gate-Potentials (VGATE), und das Gate des zweiten Transistors gekoppelt ist mit einem Ausgang (150) des Sensors,
wobei die Reihenverbindung der Transistoren (100, 102) und der Last (3) verbunden ist zwischen:
einem Anschluss (122) zum Anlegen eines Potentials (HVDD) zum Betreiben der Last, mit dem der Drain des ersten Transistors (100), der Drain des zweiten Transistor(s) (102) und der Drain des dritten Transistors (104) verbunden sind;
und einem Anschluss (120) zum Anlegen eines Referenzpotentials (GND), wobei der dritte Transistor (104) in Reihe mit einem ersten Widerstand (140) verbunden ist, der einen ersten Anschluss aufweist, der mit der Source des dritten Transistors (104) verbunden ist, und der einen zweiten Anschluss aufweist, der mit dem Anschluss (120) zum Anlegen des Referenzpotentials (GND) verbunden ist,
wobei jeder Sensor (130) mit dem Gate des zweiten Transistor(s) (102) über eine Steuerschaltung gekoppelt ist, die Folgendes aufweist:
einen vierten Transistor (106), der in Reihe mit einem zweiten Widerstand (142) verbunden ist, der einen ersten Anschluss aufweist, der mit dem Drain des vierten Transistors (106) verbunden ist, und der einen zweiten Anschluss aufweist, der mit einem Anschluss (126) zum Anlegen eines Steuerpotentials (LVDD) verbunden ist;
und einen fünften Transistor (108), der in Reihe mit einem dritten Widerstand (144) verbunden ist, der einen ersten Anschluss aufweist, der mit dem Drain des fünften Transistors (108) verbunden ist, und der einen zweiten Anschluss aufweist, der mit dem Anschluss (126) zum Anlegen des Steuerpotentials (LVDD) verbunden ist,
wobei das Gate des zweiten Transistors (102) verbunden ist zwischen dem fünften Transistor (108) und dem dritten Widerstand (144),
wobei das Gate des vierten Transistors (106) verbunden ist mit einem Knoten (150) zur Zusammenschaltung des dritten Transistors (104) und des ersten Widerstands (140), und
wobei das Gate des fünften Transistors (108) verbunden ist zwischen dem vierten Transistor (106) und dem zweiten Widerstand (142).

2. Schaltung nach Anspruch 1, die eine Vielzahl von zweiten Transistoren (102) und eine Vielzahl von Sensoren (130) aufweist, wobei das Gate jedes zweiten Transistors gekoppelt ist mit dem Ausgang (150) eines zugeordneten Sensors (130).

3. Schaltung nach Anspruch 1, die eine Vielzahl von zweiten Transistoren (102) aufweist, wobei die Gates der zweiten Transistoren (102) gekoppelt sind mit dem Ausgang (150) eines gemeinsamen Sensors (130).

4. Schaltung nach Anspruch 1, die eine erste Anzahl von zweiten Transistoren (102) und eine zweite Anzahl von Sensoren (130) aufweist, die kleiner ist als die erste Anzahl, wobei jeder Sensor einem oder einer Vielzahl von zweiten Transistoren zugeordnet ist.

5. Schaltung nach einem der Ansprüche 1 bis 4, wobei die parallele Verbindung der Transistoren (100, 102) zwischen einem und fünfzig zweiten Transistoren (102) aufweist, vorzugsweise zwischen einem und zwanzig zweiten Transistoren, mehr bevorzugt drei oder vier zweite Transistoren.

6. Schaltung nach einem der Ansprüche 1 bis 5, wobei ein leitender oder nicht-leitender Zustand des zweiten Transistors (102) abhängt von der Spannung, die an dem Knoten (150) zur Zusammenschaltung des dritten Transistors (104) und des ersten Widerstands (140) vorhanden ist.

7. Verfahren zum Steuern einer Schaltung (1; 2; 4) nach einem der Ansprüche 1 bis 6, wobei der zweite Transistor (102) gesteuert wird gemäß einem zu der Last (3) übertragenen Strom (I), wobei der Strom durch den wenigstens einen Sensor (130) bewertet wird.

8. System (7), das Folgendes aufweist:
eine Schaltung (1; 2; 4) nach einem der Ansprüche 1 bis 6;
eine Last (3; 74);
und eine Stromquelle (72).

9. Elektrofahrzeug (9), das ein System (7) nach Anspruch 8 aufweist.

## Claims

1. Circuit (1; 2; 4), intended to be associated in series with a load to be powered (3), comprising:
a first field-effect transistor (100);
at least one second field-effect transistor (102), in parallel on the first transistor; and
at least one sensor (130) of information representative of a current (I) transmitted to said load, each sensor (130) comprising a third field-effect transistor (104), the gate of the first transistor (100) and the gate of the third transistor (104) being coupled, preferably connected, to a same terminal (124) of application of a gate potential (VGATE) and the gate of the second transistor being coupled to an output (150) of said sensor,
wherein the series connection of the transistors (100, 102) and of the load (3) is connected between:
a terminal (122) of application of a potential (HVDD) powering the load, to which the drain of the first transistor (100), the drain of the second transistor(s) (102), and the drain of the third transistor (104) are connected; and
a terminal (120) of application of a reference potential (GND),
the third transistor (104) being associated in series with a first resistance (140), having a first terminal connected to the source of the third transistor (104) and having a second terminal connected to the terminal (120) of application of the reference potential (GND),
wherein each sensor (130) is coupled to the gate of the second transistor(s) (102) via a control circuit comprising:
a fourth transistor (106) associated in series with a second resistor (142), having a first terminal connected to the drain of the fourth transistor (106) and having a second terminal connected to a terminal (126) of application of a control potential (LVDD); and
a fifth transistor (108) associated in series with a third resistor (144), having a first terminal connected to the drain of the fifth transistor (108), and having a second terminal connected to the terminal of application (126) of the control potential (LVDD),
the gate of the second transistor (102) being connected between the fifth transistor (108) and the third resistor (144), the gate of the fourth transistor (106) being connected to a node (150) of interconnection of the third transistor (104) and of the first resistor (140), and the gate of the fifth transistor (108) being connected between the fourth transistor (106) and the second resistor (142).

2. Circuit according to claim 1 comprising a plurality of second transistors (102) and a plurality of sensors (130), the gate of each second transistor being coupled to the output (150) of an associated sensor (130).

3. Circuit according to claim 1 comprising a plurality of second transistors (102), the gates of the second transistors (102) being coupled to the output (150) of a common sensor (130).

4. Circuit according to claim 1 comprising a first number of second transistors (102) and a second number of sensors (130), smaller than the first number, each sensor being associated with one or a plurality of second transistors.

5. Circuit according to any one of claims 1 to 4, wherein the parallel association of the transistors (100, 102) comprises between one and fifty second transistors (102), preferably between one and twenty second transistors, more preferably three or four second transistors.

6. Circuit according to any one of claims 1 to 5, wherein a conductive or non-conductive state of the second transistor (102) depends on the voltage present at said node (150) of interconnection of the third transistor (104) and of the first resistor (140).

7. Method of controlling a circuit (1; 2; 4) according to any one of claims 1 to 6, wherein the second transistor (102) is controlled according to a current (I) transmitted to the load (3), the current being evaluated by said at least one sensor (130).

8. System (7) comprising:
a circuit (1; 2; 4) according to any one of claims 1 to 6;
a load (3; 74); and
a power source (72).

9. Electric vehicle (9) comprising a system (7) according to claim 8.
